# FASCICULE DE BREVET EUROPEEN

(11) **EP 4 530 639 B1**
(45) Date de publication et mention de la délivrance du brevet: **15.04.2026**
(21) Numéro de dépôt: 24203166.4
(22) Date de dépôt: 27.09.2024
(51) Int. Cl.: G01R 1/20, G01R 3/00, H01C 17/00

(54) **PROCÉDÉ DE FABRICATION D'UN CAPTEUR DE COURANT ÉLECTRIQUE PAR FABRICATION ADDITIVE**
VERFAHREN ZUR HERSTELLUNG EINES ELEKTRISCHEN STROMSENSORS DURCH ADDITIVE FERTIGUNG
METHOD FOR MANUFACTURING AN ELECTRIC CURRENT SENSOR BY ADDITIVE MANUFACTURING

(30) Priorité: 27.09.2023 FR 2310267
(43) Date de publication de la demande: 02.04.2025
(73) Titulaire: Commissariat à l'Energie Atomique et aux Energies Alternatives, 75015 Paris (FR); Leach International Europe SAS, 57430 Sarralbe (FR)
(72) Inventeur: FENDLER, Manuel, 38054 Grenoble (FR); FRANCK, Maxime, 57430 Sarralbe (FR); LACONDEMINE, Tanguy, 38054 Grenoble (FR)
(74) Mandataire: Gevers & Orès

(56) Documents cités:
- US-A1- 2018 174 721
- US-A1- 2020 182 936

## Description

### Domaine technique de l'invention

L'invention se rapporte au domaine de la fabrication de capteurs de courant électrique, par exemple un shunt électrique.

### Arrière-plan technique

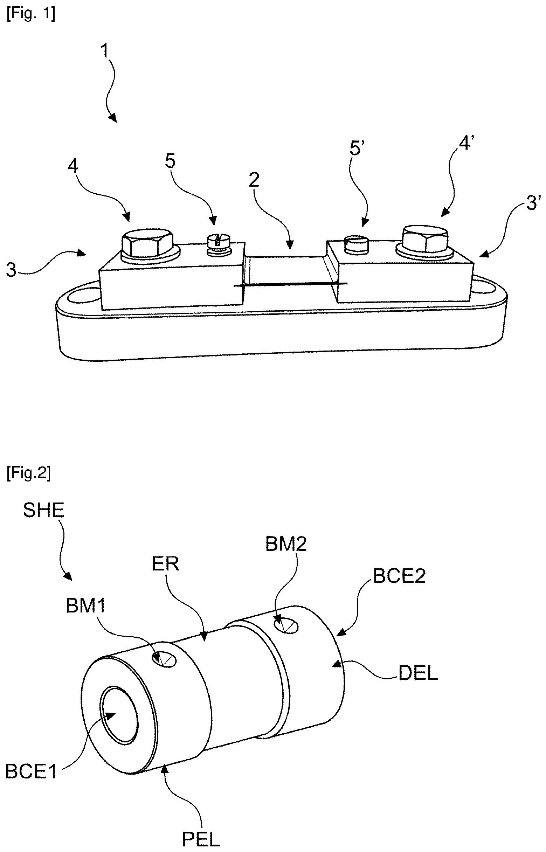

Un shunt électrique connu est représenté sur la figure 1.

Typiquement, un shunt 1 de mesure électrique est composé d'un élément résistif calibré 2, d'électrodes 3, 3', de bornes de connexion électrique 4, 4' et de bornes de mesures 5, 5' définies sur les électrodes 3, 3' respectivement. Les bornes de connexion électriques 4, 4' permettent le passage d'un courant électrique sous l'effet d'une différence de potentiel (tension), qui peut être mesurée entre les bornes de mesures 5, 5'. Grâce à la valeur calibrée de la résistance de l'élément résistif 2 et à la mesure de tension aux bornes de mesures, on peut déduire le courant électrique traversant le shunt de mesure électrique 1, en utilisant la loi d'Ohm.

Le calibrage de l'élément résistif 2 est généralement assuré par un usinage localisé de l'élément résistif. On pourra par exemple se référer à WO 2017/065144 A1 dans lequel on propose de réaliser des entailles sur l'élément résistif 2 alors que celui-ci est alimenté électriquement, afin d'ajuster la valeur de sa résistance (calibration in-situ, en cours de mesure). En variante, le calibrage de l'élément résistif 2 peut également se faire par réglage mécanique lors du montage du shunt électrique 1, en contrôlant géométriquement la surface de contact entre deux éléments résistifs. C'est par exemple ce qui est proposé dans WO 2019/190144 A1 ou WO 02/56320 A1.

L'élément résistif 2 est généralement réalisé en un alliage à base de Cuivre. Les matériaux à base de cuivre utilisés pour l'élément résistif 2 possèdent typiquement des résistivités comprises entre 20 et 50 µΩ.cm, et des coefficients de température de résistance (variation de résistivité en fonction de la température) maximum de ± 30.10⁻⁶.K⁻¹. La composition de ces alliages (Cuivre, Manganèse, Nickel, Etain, Fer, Silicium) leur confère des caractéristiques électriques qui garantissent la précision et la fiabilité de la mesure sur une plage de température de fonctionnement allant de 0°C à 175 °C. On pourra par exemple se référer à WO 2022/044611 A1 ou WO 2022/030071 A1.

Par ailleurs, l'élément résistif 2 est usuellement brasé aux électrodes 3, 3' avec de l'Argent 6, 6'. Cet assemblage par brasage avec de l'Argent limite l'utilisation à certains matériaux. De ce fait, les électrodes 3, 3' sont principalement réalisées en Cuivre ou avec un alliage à base de Cuivre. Il est à noter que l'assemblage de l'élément résistif 2 avec les électrodes 3, 3', a fait l'objet de nombreuses publications. On peut par exemple citer WO 2011/068205 A1, WO 2017/110354 A1 et WO 2015/080333 A1.

L'assemblage des bornes de connexion électrique 4, 4' aux électrodes 3, 3' a également fait l'objet de publications. On pourra notamment citer WO 2019/097924 A1, WO2019/097925 A1 et KR10-2016-0101251, avec notamment des propositions pour diminuer ou supprimer la résistance de contact entre les bornes de connexion électrique et les électrodes.

On note donc qu'il existe de multiples manières d'assembler les divers éléments du shunt de mesure électrique, telles que : le collage par pression, le brasage, le soudage (résistance électrique, laser, faisceau d'électron) et le moulage métallique. Chaque procédé d'assemblage doit être compatible avec les matériaux (élément résistif, électrode et borne de mesures), assurer une bonne conductivité électrique entre les éléments assemblés (minimiser la résistance de contact), et garantir la tenue mécanique de l'assemblage du shunt de mesure électrique.

Il convient aussi de noter que les géométries et dimensions des éléments résistifs ont une influence sur le comportement thermique et électrique des shunts de mesure électrique.

On trouve ainsi des formes de barre massive, des formes basées sur une multitude de barres fines (WO 2017/065144 A1, WO 2019/190144A1, CN209231398U), ou des formes de tiges ou tubes (WO 2018/150870 A1, WO 2013/005824 A1, WO 2011/068205 A1). En particulier, la forme de tube permet de limiter les pertes par effet Joule en mettant à profit l'effet de peau lors du passage de courant alternatifs.

US 2018/174721 A1 divulgue une résistance comprenant une première électrode, une deuxième électrode et un élément résistif disposé entre la première et la deuxième électrode.

Dans tous les cas, les matériaux des éléments résistifs étant sélectionnés en fonction de leur propriétés électriques (résistivité et coefficient de température de résistance), cela conditionne le choix des matériaux des électrodes, très majoritairement à base de cuivre. En effet, l'élément résistif et les électrodes doivent pouvoir être assemblées et posséder des propriétés électriques et thermiques compatibles, sans compter la résistance de contact induite entre les différents éléments du shunt de mesure.

Aussi, les procédés de fabrication (techniques d'assemblage et de calibration) sont des facteurs limitant l'optimisation géométrique et dimensionnelle des shunts de mesure électriques. Les zones de contacts entre l'éléments résistif, les électrodes, les bornes de connexion et de mesures doivent toutes être accessible pour permettre un assemblage par brasage, soudage ou moulage. De plus, la reprise par usinage de l'élément résistif pour effectuer la calibration constitue une étape de post-fabrication supplémentaire.

Un objectif de l'invention est de proposer un procédé de fabrication d'un capteur de courant électrique ne présentant pas l'un au moins des inconvénients précités.

### Résumé de l'invention

Pour résoudre cet objectif, l'invention propose un procédé de fabrication d'un capteur de courant électrique comportant les étapes suivantes :
a) fournir un substrat en métal ou en alliage métallique,
b) réaliser une cavité non traversante dans ledit substrat de sorte que ladite cavité sépare le substrat en deux zones,
c) réaliser, par fabrication additive, un élément résistif dans ladite cavité,
d) effectuer un recuit de l'ensemble ainsi obtenu,
e) supprimer une partie du substrat pour ne laisser que l'élément résistif entre les deux zones du substrat, et
f) définir, au sein de chaque zone, une borne de connexion pour obtenir des électrodes.

Le procédé selon l'invention pourra comprendre l'une au moins des étapes additionnelles suivantes, prises seules ou en combinaison :
- le substrat fourni à l'étape a) est en Aluminium, en Cuivre ou en un alliage à base de Cuivre ;
- la cavité réalisée à l'étape b) est obtenue par usinage du substrat ;
- l'étape c) est réalisée par pulvérisation à froid, avantageusement à pression inférieure à 15 bar ;
- l'étape d) est effectuée à une température comprise entre 400 et 600 °C pendant une durée comprise entre 5 et 15 minutes ;
- le procédé comporte une étape additionnelle consistant à réaliser une borne de mesure dans chacune des deux électrodes ;
- l'élément résistif ne subit aucune étape d'usinage, en particulier pour adapter la valeur de sa résistivité ;
- le substrat fourni à l'étape a) est un cylindre plein ;
- le substrat fourni à l'étape a) est un parallélépipède plein ;
- le capteur est un shunt électrique.

### Brève description des figures

D'autres objets et caractéristiques de l'invention apparaîtront plus clairement dans la description qui suit, faite en référence aux figures annexées, dans lesquelles :
La [Fig. 2] représente un shunt électrique, de forme cylindrique creuse, obtenu avec le procédé de fabrication selon l'invention, ;
La [Fig. 3] représente un procédé de fabrication conforme à l'invention du shunt électrique représenté sur la [Fig. 2] ;
La [Fig. 4a] est un schéma représentant une installation pour mettre en œuvre un procédé de fabrication additive par pulvérisation à froid (« Cold Spray ») à basse pression ;
La [Fig. 4b] est un schéma représentant une installation pour mettre en œuvre un procédé de fabrication additive par pulvérisation à froid (« Cold Spray ») à haute pression ;
La [Fig. 5a] représente un substrat susceptible d'être employé pour débuter le procédé de fabrication selon l'invention ;
La [Fig. 5b] représente le substrat de la [Fig. 5a] après avoir été usiné ;
La [Fig. 5c] représente l'ensemble formé après dépôt par fabrication additive d'un élément résistif dans un orifice non traversant du substrat usiné de la [Fig. 5d] ;
La [Fig. 5d] représente le shunt électrique finalement obtenu après recuit et percement de part en part de l'ensemble de la [Fig 5c] ;
La [Fig. 6] représente le shunt électrique après avoir ajouté des bornes de mesure ;

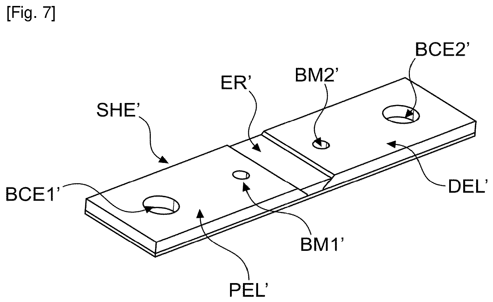

La [Fig. 7] représenté un shunt électrique, de type « busbar », obtenu avec le procédé de fabrication selon l'invention.

### Description détaillée de l'invention

La description qui suit est faite dans le cas où le capteur de courant électrique est un shunt électrique. Toutefois, l'invention n'est pas limitée à la fabrication d'un shunt électrique.

La figure 2 est un exemple de réalisation d'un shunt électrique SHE, en l'occurrence de de forme cylindrique creuse, obtenu selon le procédé selon l'invention.

Le shunt électrique SHE comprend une première électrode PEL, une deuxième électrode DEL et un élément résistif ER entre les deux électrodes PEL, DEL. Chaque électrode PEL comporte une borne de connexion associée BCE1, BCE2 respectivement en l'occurrence située aux extrémités du shunt électrique. Une borne de mesure BM1, BM2 est également prévue sur chaque électrode PEL, DEL. Dans cette réalisation, les électrodes PEL, DEL tout comme l'élément résistif forment des cylindres creux.

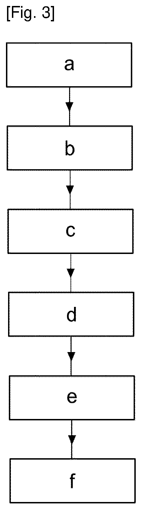

La figure 3 représente de manière schématique les différentes étapes du procédé de fabrication d'un capteur de courant électrique tel qu'un shunt électrique SHE, en particulier celui qui est représenté sur la figure 2, à savoir:
a) fournir un substrat SBT en métal ou en alliage métallique,
b) réaliser une cavité CVT non traversante dans ledit substrat de sorte que ladite cavité sépare le substrat en deux zones Z1, Z2,
c) réaliser, par fabrication additive, un élément résistif ER dans ladite cavité CVT,
d) effectuer un recuit de l'ensemble ainsi obtenu à l'issue de l'étape c),
e) supprimer une partie du substrat SBT pour ne laisser que l'élément résistif ER entre les deux zones Z1, Z2 du substrat, et
f) définir, au sein de chaque zone Z1, Z2, une borne de connexion BCE1, BCE2 pour obtenir lesdites électrodes PEL, DEL.

Le substrat SBT fourni à l'étape a) peut être en Aluminium, en Cuivre ou en un alliage à base de Cuivre et plus généralement en tous métaux ou alliages métalliques conducteurs de l'électricité. Le procédé selon l'invention, du fait de l'emploi d'une étape de fabrication additive, permet notamment l'emploi d'une gamme élargie de métaux ou alliages métalliques, tout en limitant les résistances de contact entre l'élément résistif ER et les électrodes PEL, DEL. Il est donc en particulier possible d'utiliser de l'Aluminium, qui a l'avantage d'être beaucoup plus léger que les alliages à base de Cuivre. Cela peut être d'importance pour certaines applications.

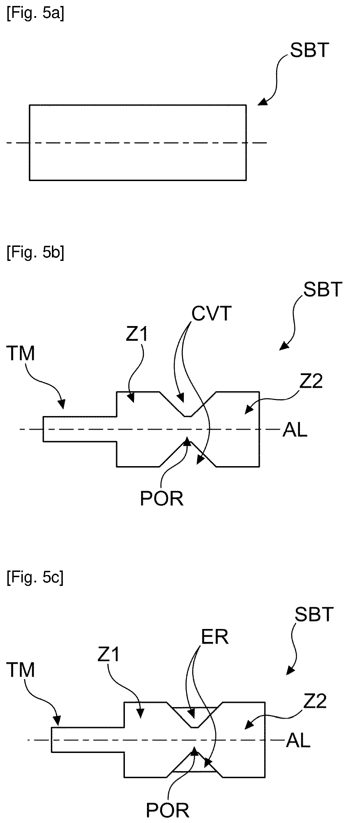

Le substrat fourni à l'étape a) est représenté sur la figure 5a. Il s'agit d'un cylindre plein.

La cavité CVT non traversante réalisée à l'étape b) est par exemple obtenue par usinage du substrat SBT. Ceci sera notamment le cas lorsqu'on fournit à l'étape a) un substrat cylindrique plein, à partir duquel de la matière sera ensuite retirée pour obtenir la forme finale souhaitée du shunt électrique SHE. La cavité CVT étant non traversante, il reste à ce stade une portion POR de substrat reliant deux zones Z1, Z2 de ce même substrat quant à elles situées de part et d'autre de la cavité CVT.

Selon une variante de réalisation, on peut envisager de fusionner les étapes a) et b) en réalisant une fabrication additive du substrat SBT à la forme souhaitée. Ceci peut s'effectuer par un procédé nommé « Cold Spray » selon la terminologie anglo-saxonne (ou « pulvérisation à froid » en français), ou encore par un procédé nommé « dépôt d'énergie directe ».

A l'issue de l'étape b), on obtient un substrat tel que défini à la figure 5b). Comme on peut le constater sur cette figure, le substrat comporte en l'occurrence une tige de maintien TM qui n'a d'utilité que pour manipuler le substrat SBT lors de certaines étapes du procédé de fabrication. Cette tige de maintien TM est destinée à disparaître dans a suite du procédé de fabrication.

Pour mettre en œuvre l'étape c), différentes techniques de fabrication additive sont envisageables.

On peut ainsi avantageusement employer le procédé « Cold Spray » selon la terminologie anglo-saxonne, ou « pulvérisation à froid » en français. Le procédé « Cold Spray » (aussi connu sous le nom de « Gas Dynamic Spraying » ou encore « Kinetic Spraying Process » selon la terminologie anglo-saxonne) est un procédé de dépôt de revêtement basé sur la projection supersonique de poudre solide à une température inférieure à la température de fusion des matériaux formant les grains poudre. C'est l'énergie cinétique acquise par les grains de poudre qui permet de déformer plastiquement les matériaux les constituant afin d'assurer l'adhérence du dépôt. Les températures mises en jeux dans ce procédé sont inférieures aux températures mises en jeu autres procédés de projection thermique.

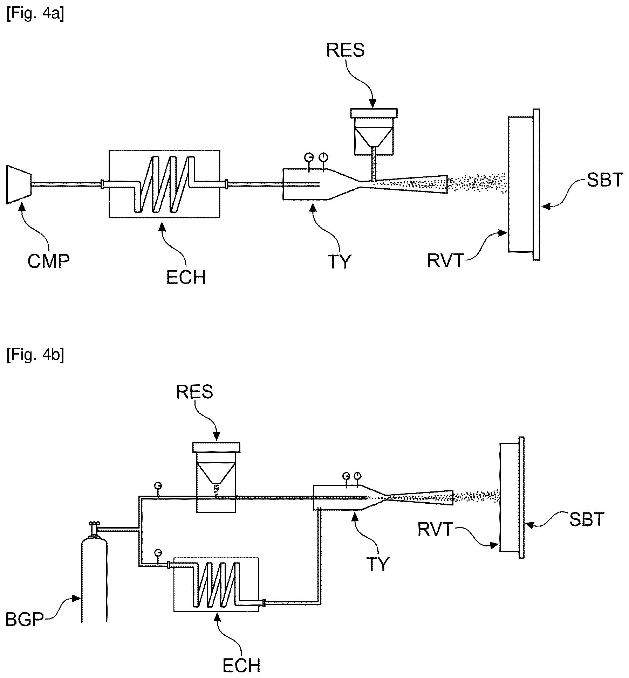

On a représenté sur la figure 4a, une installation pour mettre en œuvre un procédé de dépôt par « Cold Spray », fonctionnant à basse pression (plus connu sous l'acronyme LPCS pour « Low Pressure Cold Spray » selon la terminologie anglo-saxonne).

Plus précisément, l'installation comprend un compresseur CMP permettant d'injecter un gaz porteur, par exemple de l'air ou de l'azote, dans un réchauffeur ou échangeur de chaleur ECH. Le gaz en sortant est ainsi mis sous pression, typiquement à des pressions inférieures à 15 bar (basse pression) et sous température, typiquement inférieure à 1000°C et en tout cas inférieure à la température de fusion du matériau formant les grains de poudre, avant d'entrer dans une tuyère TY, typiquement une tuyère de Laval. La tuyère TY permet de détendre le gaz préalablement chauffé et mis sous pression et ainsi d'accélérer la vitesse du jet de gaz afin de le rendre supersonique. Un réservoir de poudre RES permet quant à lui d'injecter de la poudre dans la tuyère TY, par exemple en aval du col de la tuyère, avec des grains de matériau choisi. En sortie de la tuyère, la poudre est projeté contre un substrat SBT pour déposer un revêtement RVT qui peut se présenter sous la forme d'une ou plusieurs couches successives. Par ailleurs, la ou chaque couche du revêtement déposé peut l'être de différentes façons, par exemple en spirale, par anneaux de différents diamètres ou encore suivant des génératrices parallèles, etc. Classiquement, on peut ainsi projeter des particules de 5 à 50 µm à des vitesses d'environ 600 m/s. Le LPCS est généralement utilisé pour la projection de matériaux « tendres ». Le matériau projeté sous forme de poudre peut être mélangé à de l'alumine (sous forme de poudre également) pour augmenter le rendement et la densité du dépôt.

En ce qui concerne le LPCS, on pourra par exemple se référer à l'article de Shuo Yin, Pasquale Cavaliere, Barry Aldwell, Richard Jenkins, Hanlin Liao, Wenya Li, Rocco Lupoi, « Cold spray additive manufacturing and repair: Fundamentals and applications », Additive Manufacturing, Volume 21, 2018, Pages 628-650, ISSN 2214-8604, https://doi.org/10.1016/j.addma.2018.04.017.

On a représenté sur la figure 4b, une autre installation pour mettre en œuvre un procédé de dépôt par « Cold Spray », fonctionnant à haute pression (plus connu sous l'acronyme HPCS pour « High Pressure Cold Spray » selon la terminologie anglo-saxonne).

Plus précisément, l'installation comprend une bouteille de gaz sous pression BGP permettant d'injecter un gaz porteur, par exemple de l'air, de l'azote ou de l'hélium, dans deux circuits parallèles, l'un comportant un réchauffeur ou échangeur de chaleur ECH, l'autre comportant un réservoir de poudre RES agencé pur injecter de la poudre dans le circuit concerné. Les deux circuits sont ensuite combinés avant d'entrer dans une tuyère TY, par exemple une tuyère de Laval. Le gaz issu des circuits est ainsi mis sous pression, typiquement à des pressions supérieures à 15 bar (haute pression) et sous température, qui peuvent ici dépasser les 1000°C tout en restant à une température inférieure à la température de fusion du matériau formant les grains de poudre, avant d'entrer dans la tuyère TY. La tuyère TY permet de détendre le gaz préalablement chauffé et mis sous pression et ainsi d'accélérer la vitesse du jet de gaz afin de le rendre supersonique. En sortie de la tuyère TY, la poudre est projeté contre un substrat SBT pour déposer un revêtement RVT qui peut se présenter sous la forme d'une ou plusieurs couches successives. Par ailleurs, la ou chaque couche du revêtement RVT déposé peut l'être de différentes façons, par exemple en spirale, par anneaux de différents diamètres ou encore suivant des génératrices parallèles, etc. Classiquement, on peut ainsi projeter des particules de 5 à 50 µm à des vitesses susceptibles d'aller au-delà des 1000 m/s. Le HPCS est généralement utilisé pour la projection de matériaux « durs », comme le titane.

Dans le cadre des applications visées par l'invention, on pourra avantageusement mettre en œuvre un « Cold Spray » de type LPCS (basse pression), typiquement entre 4 et 10 bars et plus particulièrement entre 4 et 8 bars, avec une poudre de granulométrie comprise entre 5 et 25 µm. Par ailleurs, le dépôt de cette poudre s'effectue alors avantageusement à une température comprise entre 400°C et 600°C. Le gaz porteur employé pour projeter la poudre contre le substrat comme l'air est particulièrement bien adapté.

Le matériau constitutif de la poudre et donc de l'élément résistif ER peut être un métal, par exemple du Cuivre, du Nickel, de l'Aluminium ou du Zinc, ou un alliage métallique à base cuivre, par exemple du Manganin, du Noventin, du Zeranin ou du Constantan. En pratique, l'emploi de Manganin, de granulométrie comprise entre 5 et 25 µm est particulièrement bien adapté pour les applications visées dans la cadre de l'invention, en particulier pour le shunt électrique SHE représenté sur la figure 2. En particulier, ce Manganin peut alors être co-projeté avec de l'alumine (avantageusement avec une granulométrie inférieure ou égale à 25 µm pour augmenter le rendement et la densité du dépôt. En cas de co-projection, la quantité d'alumine, non nulle, peut représenter jusqu'à 40% en masse du mélange de poudre Alumine + Manganin. L'augmentation de rendement signifie que le rapport entre la quantité de matière déposée sur la quantité de matière projetée augmente. L'augmentation de la densité du dépôt permet de diminuer la présence de défauts (porosité, fissure, etc) et donc d'augmenter les propriétés de tenue mécanique et/ou les propriétés électrique et thermique du dépôt. On peut aussi prévoir une étape de sablage avec de la poudre d'alumine de granulométrie importante, par exemple 250 microns, avant la projection de la poudre pour fabriquer l'élément résistif ER et ce, afin d'augmenter la rugosité du substrat et par suite l'accroche mécanique de l'élément résistif ER sur le substrat SBT destiné à former les électrodes PEL, DEL.

En variante, toujours dans le cadre des applications visées par l'invention, on peut partir d'une poudre avec une granulométrie comprise entre 15 et 45 µm en fonctionnant à haute pression, à savoir entre 10 à 60 bars. Les températures associées peuvent alors être comprises entre 400 et 600°C.

De manière générale, toujours dans le cadre des applications visées par l'invention, on peut donc fonctionner avec un procédé de type « Cold Spray » avec une pression allant de 4 à 60 bars (basse pression allant de 4 à 10 bars ou haute pression allant de 10 à 60 bars), avec des températures susceptibles de couvrir une large gamme allant de 20°C à 1000°C, en particulier en fonction de la nature du matériau formant la poudre (listé plus haut) et de sa granulométrie (susceptible d'aller de 5 à 65 µm), avec un gaz vecteur comme l'air, l'Argon ou l'Hélium.

Des techniques de fabrication additive autres que la « Cold Spray » peuvent être employées. Ainsi, on peut envisager une fabrication additive de l'élément résistif ER par une technique dite de « Dépôt d'Energie Direct » (DED) et/ou par une technique dite « Fusion sur Lit de Poudre par Laser (FLPL) » qui permettent, tout comme la technique « Cold Spray », de contrôler et de varier la composition du dépôt en cours de fabrication.

Plusieurs stratégies d'obtention de l'élément résistif ER sont alors possibles :
- Dépôt de l'alliage résistif (Cold Spray, DED, FLPL) : la composition et les propriétés sont fixées,
- Dépôt combinatoire avec fusion direct (DED, FLPL), permet de créer un alliage à façon avec refusions des précurseurs d'alliages (e.g. : Cu, Mn, Ni, Sn, Fe, Si),
- Dépôt combinatoire avec post-process localisé (« Cold Spray » + post-traitement par friction ou Laser) : permet d'obtenir un dépôt contenant tous les précurseurs d'alliages et d'appliquer un post-traitement pour obtenir les propriétés électriques souhaitées de manière localisée.

Ainsi, la composition et les gradients de compositions des éléments résistifs sont déterminés en fonction des propriétés électriques visées sans se restreindre aux strictes alliages (commerciaux) généralement utilisés.

A l'issue de l'étape c), on arrive à un ensemble tel que représenté sur la figure 5c.

Le recuit réalisé à l'étape d) peut viser à restaurer les propriétés mécaniques et électriques des matériaux ou, à relâcher les contraintes mécaniques et augmenter la tenue du dépôt. Selon le cas, les conditions du recuit ne sont pas les mêmes. Ainsi, le recuit peut être effectué à une température comprise entre 150 et 300°C pendant une durée allant de 15 à 60 minutes pour restaurer les propriétés mécaniques et électriques des matériaux (recuit de restauration). Ainsi également, le recuit peut être effectué à une température de l'ordre de 300°C pendant une durée d1 heure ou plus, pour relâcher les contraintes mécaniques (recuit de recristallisation) et augmenter la tenue du dépôt. Le recuit peut être réalisé sous air ou sous atmosphère contrôlée. Typiquement, pour les matériaux cuivreux (comme le manganin), les recuits peuvent être réalisés sous air ou sous atmosphère contrôlé, à des températures élevées jusqu'à 600°C (recuit de recristallisation), ou à des température plus faibles d'environ 200 °C (recuit de restauration), sachant qu'il convient en parallèle tenir compte de la température de fusion du matériau formant le substrat (par exemple pour l'aluminium, la température de fusion est de 660°C mais il peut néanmoins commencer à s'écouler sous contrainte à partir de 450°C).

Une fois le recuit effectué, on supprime, lors d'une étape e) du procédé selon l'invention, une partie du substrat SBT pour ne laisser que l'élément résistif ER entre les deux zones Z1, Z2 du substrat. Appliquée à la fabrication du shunt électrique SHE de la figure 2, cette étape consiste plus précisément à percer de part en part l'ensemble récupéré après le recuit. Cela fait disparaître la tige de maintien TM, mais aussi la zone de connexion du substrat SBT entre ces deux zones. Cela permet aussi incidemment, conformément à l'étape f) du procédé selon l'invention, de créer les deux bornes de connexion BCE1, BCE2 sur les zones Z1, Z2 afin de définir les électrodes PEL, DEL.

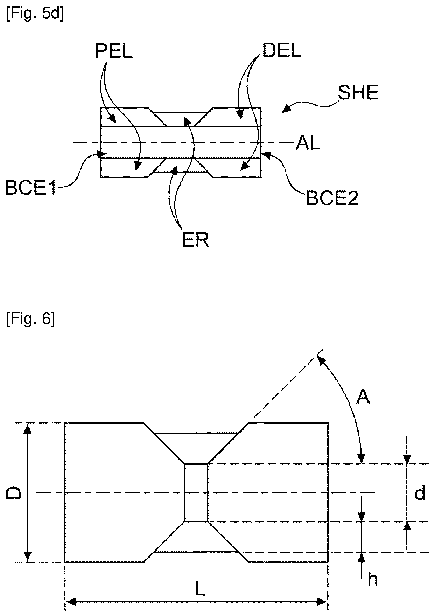

L'ensemble obtenu à l'issue de l'étape f) est représenté sur la figure 5d.

Il ne reste plus avantageusement, lors d'une étape additionnelle, à créer des bornes de mesures BM1, BM2. On obtient alors le shunt électrique représenté sur la figure 2.

Sur la figure 6, on a représenté différents paramètres permettant de concevoir le shunt électrique SHE de la figure 2 avant l'étape de percement (étape e) ci-dessus du procédé selon l'invention) de l'ensemble obtenu après le recuit :
- D désigne le diamètre extérieur des électrodes PEL, DEL avec 3,5mm < D < 50mm ;
- d désigne le diamètre intérieur des électrodes PEL, DEL avec 1,5mm < d < 20mm et dₘₐₓ = D/1,75 ;
- h désigne l'épaisseur de l'élément résistif ER, avec 1 mm < h < (D - d)/2 ;
- A désigne l'angle d'inclinaison donné à la cavité avec 1° < a < 90°, de préférence A tel que 30° < A <60°; et
- L désigne la longueur du shunt électrique avec 5 mm < L < 100 mm.

Les valeurs sont adaptées à l'application.

D'autres géométries que celle qui est représentée sur la figure 2 sont réalisables avec le procédé conforme à l'invention.

Ainsi, à titre d'exemple additionnel non limitatif, il est possible de fabriquer un shunt électrique SHE' de type « busbar » tel que représenté sur la figure 6.

Dans le cas d'espèce, on part lors de l'étape a) d'un substrat plein de forme parallélépipédique, dans lequel on peut former une cavité à la forme souhaitée lors de l'étape b), par exemple par usinage. Là également, on pourrait procéder autrement pour obtenir le substrat avec sa cavité non traversante. L'étape c) reprend alors ce qui a été décrit précédemment, tout comme l'étape d), e) et f), quelles que soient les variantes envisagées qui sont applicables aussi à cette autre géométrie. A l'issue de l'étape f), le shunt électrique SHE' est défini avec ses électrodes PEL', DEL' munies donc de bornes de connexion BCE1', BCE2', les électrodes étant reliées l'une à l'autre par le seul élément résistif ER'. Il est ensuite avantageusement aussi procédé à la réalisation de bornes de mesure BM1', BM2', comme on peut le constater sur la figure 6.

Le shunt électrique SHE, SHE' obtenu dans le cadre de l'invention peut notamment permettre de mesurer la consommation électrique ou l'état de charge de batteries dans les domaines suivants : transports (voiture, aéronautique, ferroviaire, aérospatial), métrologie, industrie et bâtiment. Ce shunt électrique trouve plus généralement application pour former toute sonde de mesure de courant alternatif (AC) ou continu (DC) pour électronique (10 à 500 A).

### Exemple de réalisation : fabrication d'un shunt électrique cylindrique creux

On fournit tout d'abord un substrat SBT plein, cylindrique, en aluminium (figure 5a), conformément à l'étape a) du procédé selon l'invention.

Le substrat est ensuite usiné pour définir une cavité CVT non traversante, conformément à l'étape b) du procédé confirme à l'invention, en l'occurrence de forme trapézoïdale en section, sur toute la périphérie du substrat. Par ailleurs, ici, l'une des extrémités du substrat est aussi usinée pour définir une tige de maintien TM utile à sa manipulation au cours du procédé de fabrication (figure 5b). La tige de maintien TM mise à part, les zones Z1, Z2 du substrat situé de part et d'autre de la cavité CVT sont celles qui sont destinées à former la première électrode et la deuxième électrode. Ces zones Z1, Z2 sont reliées entre elles par une portion POR de substrat, en l'occurrence de forme cylindrique, destinée à disparaître par la suite du procédé de fabrication.

Ensuite, on réalise une fabrication additive de l'élément résistif ER dans la cavité CVT, conformément à l'étape c) du procédé selon l'invention.

Pour cela, le procédé de fabrication additive employé est le procédé connu sous le nom de « Cold Spray » de type LPCS (basse pression). On part ainsi d'un mélange de poudre (compatible avec le procédé « Cold Spray ») de manganin avec une granulométrie de 5 à 50 µm et d'alumine de granulométrie 5 à 25 µm, l'alumine représentant 20% en masse du mélange de poudre. Le procédé est mis en œuvre à une pression de 8 bar et une température de 400 °C, sous air. Le substrat est mis en rotation continue à 60 tr/mn à une vitesse de rotation de 30 mm/mn. Le dépôt du revêtement s'effectue avec plusieurs couches successives, et pour chaque couche le dépôt s'effectue sous forme d'hélicoïdes. On profite de cette opération de fabrication additive par « Cold Spray » pour effectuer un sablage préalable de la surface du substrat, en l'occurrence avec de la poudre d'alumine de granulométrie de 250 microns. Le sablage favorise l'adhérence du dépôt effectué lors de la fabrication additive par « Cold Spray » et donc finalement la tenue mécanique de l'élément résistif sur le substrat, autrement dit in fine sur les électrodes (figure 5c).

Avec la fabrication additive, l'élément résistif ER est dimensionné pour obtenir une valeur définie de sa résistivité. On s'affranchit alors, par rapport à l'art antérieur, d'une étape d'usinage (reprise d'usinage) ultérieure de l'élément résistif pour adapter celle-ci.

Un recuit de l'ensemble obtenu à ce stade de la fabrication est ensuite effectué, conformément à l'étape d) du procédé selon l'invention. Ce recuit sert à restaurer les propriétés mécanique et électrique des différents matériaux. En l'occurrence, il s'agit d'un recuit d'1h à 300°C.

Puis, conformément à l'étape e) du procédé selon l'invention, une partie du substrat SBT est supprimée pour ne laisser que l'élément résistif ER entre les deux zones Z1, Z2 du substrat. En pratique ici, le substrat est percé de part en part le long de son axe longitudinal AL. Cette opération fait disparaître la portion POR du substrat qui reliait les deux zones Z1, Z2. On obtient ainsi la forme cylindrique creuse souhaitée.

Dans le cas d'espèce, le percement du substrat de part en part permet dans le même temps de réaliser l'étape f) conformément au procédé selon l'invention. En effet, cela permet de générer les bornes de connexion à l'extrémité de chacun des zones Z1, Z2 pour finalement former la première électrode et la deuxième électrode. Par ailleurs, dans le cadre de cet exemple de réalisation, la tige de maintien TM est également supprimée par cette même opération.

Les électrodes PEL, DEL et l'élément résistif ER sont à ce stade définis, tout comme les bornes de connexion électriques BCE1, BCE2 (figure 5d).

On pourra ensuite et avantageusement, créer des bornes de mesure BM1, BM2. Pour créer ces bornes de mesure, on peut réaliser un trou taraudé pour y fixer une cosse via une vis. On peut encore réaliser un trou, par exemple conique, pour y loger un contacteur monté sur ressort.

Fin de l'exemple.

## Revendications

1. Procédé de fabrication d'un capteur de courant électrique (SHE) comportant les étapes suivantes :
a) fournir un substrat (SBT) en métal ou en alliage métallique,
b) réaliser une cavité (CVT) non traversante dans ledit substrat de sorte que ladite cavité sépare le substrat en deux zones (Z1, Z2),
c) réaliser, par fabrication additive, un élément résistif (ER) dans ladite cavité (CVT),
d) effectuer un recuit de l'ensemble ainsi obtenu,
e) supprimer une partie du substrat (SBT) pour ne laisser que l'élément résistif (ER) entre les deux zones (Z1, Z2) du substrat, et
f) définir, au sein de chaque zone (Z1, Z2), une borne de connexion (BCE1, BCE2) pour obtenir des électrodes (PEL, DEL).

2. Procédé de fabrication d'un capteur de courant électrique selon la revendication 1, dans lequel le substrat fourni à l'étape a) est en Aluminium, en Cuivre ou en un alliage à base de Cuivre.

3. Procédé de fabrication d'un capteur de courant électrique selon l'une des revendications précédentes, dans lequel la cavité (CVT) réalisée à l'étape b) est obtenue par usinage du substrat (SBT).

4. Procédé de fabrication d'un capteur de courant électrique selon l'une des revendications précédentes, dans lequel l'étape c) est réalisée par pulvérisation à froid, avantageusement à pression inférieure à 15 bar.

5. Procédé de fabrication d'un capteur de courant électrique selon l'une des revendications précédentes, dans lequel l'étape d) est effectuée à une température comprise entre 400 et 600 °C pendant une durée comprise entre 5 et 15 minutes.

6. Procédé de fabrication d'un capteur de courant électrique selon l'une des revendications précédentes, comportant une étape additionnelle consistant à réaliser une borne de mesure (BM1, BM2) dans chacune des deux électrodes (PEL, DEL).

7. Procédé de fabrication d'un capteur de courant électrique selon l'une des revendications précédentes, dans lequel l'élément résistif (ER) ne subit aucune étape d'usinage, en particulier pour adapter la valeur de sa résistivité.

8. Procédé de fabrication d'un capteur de courant électrique selon l'une des revendications précédentes, dans lequel le substrat (SBT) fourni à l'étape a) est un cylindre plein.

9. Procédé de fabrication d'un capteur de courant électrique selon l'une des revendications 1 à 7, dans lequel le substrat (S) fourni à l'étape a) est un parallélépipède plein.

10. Procédé de fabrication d'un capteur de courant électrique selon l'une des revendications précédentes, dans lequel ledit capteur est un shunt électrique.

## Patentansprüche

1. Verfahren zur Herstellung eines elektrischen Stromsensors (SHE), das die folgenden Schritte umfasst:
a) Bereitstellen eines Substrats (SBT) aus Metall oder einer Metalllegierung,
b) Herstellen eines nicht durchgehenden Hohlraums (CVT) in dem Substrat, sodass der Hohlraum das Substrat in zwei Bereiche (Z1, Z2) unterteilt,
c) Herstellen, durch additive Fertigung, eines Widerstandselements (ER) in dem Hohlraum (CVT),
d) Ausführen eines Glühvorgangs der damit erhaltenen Baugruppe,
e) Entfernen eines Teils des Substrats (SBT), damit nur das Widerstandselement (ER) zwischen den beiden Bereichen (Z1, Z2) des Substrats verbleibt, und
f) Definieren, innerhalb jedes Bereichs (Z1, Z2), einer Verbindungsklemme (BCE1, BCE2), um Elektroden (PEL, DEL) zu erhalten.

2. Verfahren zur Herstellung eines elektrischen Stromsensors nach Anspruch 1, wobei das in Schritt a) bereitgestellte Substrat aus Aluminium, Kupfer oder einer Kupferlegierung besteht.

3. Verfahren zur Herstellung eines elektrischen Stromsensors nach einem der vorstehenden Ansprüche, wobei der in Schritt b) hergestellte Hohlraum (CVT) durch Bearbeitung des Substrats (SBT) hergestellt wird.

4. Verfahren zur Herstellung eines elektrischen Stromsensors nach einem der vorstehenden Ansprüche, wobei Schritt c) durch Kaltzerstäubung, vorteilhafterweise bei einem Druck von weniger als 15 bar, durchgeführt wird.

5. Verfahren zur Herstellung eines elektrischen Stromsensors nach einem der vorstehenden Ansprüche, wobei Schritt d) bei einer Temperatur zwischen 400 und 600 °C für eine Dauer zwischen 5 und 15 Minuten durchgeführt wird.

6. Verfahren zur Herstellung eines elektrischen Stromsensors nach einem der vorstehenden Ansprüche, umfassend einen zusätzlichen Schritt, der darin besteht, in jeder der zwei Elektroden (PEL, DEL) eine Messklemme (BM1, BM2) herzustellen.

7. Verfahren zur Herstellung eines elektrischen Stromsensors nach einem der vorstehenden Ansprüche, wobei das Widerstandselement (ER) keinem Bearbeitungsschritt unterzogen wird, insbesondere um den Wert seines spezifischen Widerstands anzupassen.

8. Verfahren zur Herstellung eines elektrischen Stromsensors nach einem der vorstehenden Ansprüche, wobei das in Schritt a) bereitgestellte Substrat (SBT) ein Vollzylinder ist.

9. Verfahren zur Herstellung eines elektrischen Stromsensors nach einem der Ansprüche 1 bis 7, wobei das in Schritt a) bereitgestellte Substrat (S) ein massiver Quader ist.

10. Verfahren zur Herstellung eines elektrischen Stromsensors nach einem der vorstehenden Ansprüche, wobei der Sensor ein elektrischer Shunt ist.

## Claims

1. A method for manufacturing an electric current sensor (SHE) comprising the following steps:
a) providing a metal or metal alloy substrate (SBT),
b) making a non-through cavity (CVT) in said substrate so that said cavity separates the substrate into two areas (Z1, Z2),
c) producing a resistive element (ER) in said cavity (CVT) by additive manufacturing,
d) annealing the resulting assembly,
e) removing a part of the substrate (SBT) to leave only the resistive element (ER) between the two areas (Z1, Z2) of the substrate, and
f) defining, within each area (Z1, Z2), a connection terminal (BCE1, BCE2) to obtain electrodes (PEL, DEL).

2. The method for manufacturing an electrical current sensor according to claim 1, wherein the substrate provided in step a) is made of Aluminum, Copper or a Copper-based alloy.

3. The method for manufacturing an electric current sensor according to one of the preceding claims, wherein the cavity (CVT) produced in step b) is obtained by machining the substrate (SBT).

4. The method for manufacturing an electric current sensor according to one of the preceding claims, wherein step c) is carried out by cold spraying, advantageously at a pressure of less than 15 bar.

5. The method for manufacturing an electric current sensor according to one of the preceding claims, wherein step d) is performed at a temperature of between 400 and 600°C for a period of between 5 and 15 minutes.

6. The method for manufacturing an electrical current sensor according to one of the preceding claims, comprising an additional step consisting in making a measurement terminal (BM1, BM2) in each of the two electrodes (PEL, DEL).

7. The method for manufacturing an electric current sensor according to one of the preceding claims, wherein the resistive element (ER) does not undergo any machining step, in particular to adapt the value of its resistivity.

8. The method for manufacturing an electrical current sensor according to any of the preceding claims, wherein the substrate (SBT) provided in step a) is a solid cylinder.

9. The method for manufacturing an electrical current sensor according to one of claims 1 to 7, wherein the substrate (S) provided in step a) is a solid parallelepiped.

10. The method for manufacturing an electrical current sensor according to one of the preceding claims, wherein said sensor is an electrical shunt.
